# EUROPÄISCHE PATENTSCHRIFT

(11) **EP 4 305 431 B1**
(45) Veröffentlichungstag und Bekanntmachung des Hinweises auf die Patenterteilung: **09.04.2025**
(21) Anmeldenummer: 22706847.5
(22) Anmeldetag: 21.02.2022
(51) Int. Cl.: G01R 27/02, G01R 31/66, G01R 27/20, G01R 27/16

(54) **VERFAHREN ZUM ERFASSEN EINES ÜBERGANGSWIDERSTANDS EINER BERÜHRSICHEREN SCHNITTSTELLE UND SCHNITTSTELLE**
METHOD FOR DETECTING A CONTACT RESISTANCE OF A TOUCH-SAFE INTERFACE, AND INTERFACE
PROCÉDÉ DE DÉTECTION DE RÉSISTANCE AU CONTACT D'UNE INTERFACE SANS DANGER AU TOUCHER ET INTERFACE

(30) Priorität: 09.03.2021 DE 102021105605
(43) Veröffentlichungstag der Anmeldung: 17.01.2024
(73) Patentinhaber: Lisa Dräxlmaier GmbH, 84137 Vilsbiburg (DE)
(72) Erfinder: GRUBER, Christian, 84155 Bodenkirchen (DE); EMSLANDER, Stephan, 85368 Moosburg (DE)
(86) Internationale Anmeldenummer: PCT/EP2022/054255
(87) Internationale Veröffentlichungsnummer: WO 2022/189130

(56) Entgegenhaltungen:
- CN-U- 204 203 356
- DE-A1- 102015 221 725
- DE-A1- 2 055 477
- US-A1- 2002 153 901
- DREIER JÜRGEN: "Determination of resistances Quality of electrical connections in power distribution", 31 July 2019 (2019-07-31), pages 1 - 4, XP055920497, Retrieved from the Internet <URL:https://www.kocos.com/fileadmin/download/PROMET/Technical_Papers/ENG/TP_Quality_of_electrical_connections_in_power_distribution_201907_ENG.pdf> [retrieved on 20220512]

## Beschreibung

### Technisches Gebiet

Die vorliegende Erfindung betrifft ein Verfahren zum Erfassen eines Übergangswiderstands einer berührsicheren Schnittstelle zwischen einer ersten Hochvoltkomponente und einer zweiten Hochvoltkomponente sowie eine entsprechende Schnittstelle.

### Stand der Technik

Die vorliegende Erfindung wird im Folgenden hauptsächlich in Verbindung mit Hochvoltkomponenten von Fahrzeugen beschrieben. Die Erfindung kann aber für jede Anwendung genutzt werden, in der ein Übergangswiderstand einer schlecht zugänglichen Schnittstelle gemessen werden soll.

Hochvoltkomponenten eines Fahrzeugs sind durch eine Isolierung berührsicher geschützt. Die Isolierung verhindert eine Berührung der Hochvoltkomponenten durch Montagepersonal und Werkstattpersonal. Dazu wird die Isolierung unter Verwendung eines genormten Prüffingers geprüft. Der Prüffinger darf an keinem Ort näher als einen Mindestabstand an stromführende Teile kommen.

Die Veröffentlichung Dreier Jürgen: "Determination of resistances Quality of electrical connections in power distribution", 31. Juli 2019), beschreibt ein kompaktes, batteriebetriebenes Ohmmeter, geeignet für Kontaktwiderstandsprüfungen, und gibt ein Beispiel für den Anschluss des Messgeräts an eine Verschraubung zweier Hochspannungsstromschienen.

Aus der Druckschrift CN 204 203 356 U ist ein Messgerät zum Messen des elektrischen Hochspannungskontaktwiderstands einer Schleife bekannt, um den Widerstandswert zu berechnen.

Die Druckschrift DE 10 2015 221725 A1 betrifft ein Verfahren zum Überwachen eines elektrischen Bordnetzes.

Die Druckschrift US 2002/153901 A1 betrifft ein Verfahren und eine Vorrichtung zum Messen einer unbekannten Impedanz, ohne die Komponenten aus einem Schaltkreis zu entfernen.

### Beschreibung der Erfindung

Eine Aufgabe der Erfindung ist es daher, unter Einsatz konstruktiv möglichst einfacher Mittel ein verbessertes Verfahren zum Erfassen eines Übergangswiderstands einer berührsicheren Schnittstelle zwischen einer ersten Hochvoltkomponente und einer zweiten Hochvoltkomponente sowie eine verbesserte Schnittstelle bereitzustellen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Hochvoltkomponenten eines Hochvoltsystems eines Fahrzeugs können ohne stoffschlüssige Verbindung miteinander verbunden sein. Die Hochvoltkomponenten können also kraftschlüssig und/oder formschlüssig miteinander verbunden sein. Die Hochvoltkomponenten können dabei beispielsweise verschraubt, gesteckt, geklemmt oder vernietet sein.

Die Hochvoltkomponenten weisen stromführende Teile aus einem Metallmaterial auf. Insbesondere können Hochvoltkomponenten stromführende Teile aus einer Kupferlegierung oder Aluminiumlegierung aufweisen. Das Metallmaterial kann beispielsweise durch Luftkontakt eine chemisch veränderte oberflächliche Schicht aufweisen. Beispielsweise kann das Metallmaterial eine Oxidschicht aufweisen. Die Schicht kann einen größeren elektrischen Widerstand aufweisen als das Metallmaterial selbst.

Wenn zwei Hochvoltkomponenten miteinander verbunden sind, können im schlimmsten Fall zwei Oberflächenschichten mit erhöhtem elektrischem Widerstand aneinander anliegen und so einen Übergangswiderstand zwischen den Hochvoltkomponenten maßgeblich beeinflussen.

Die Hochvoltkomponenten können von allen Seiten durch eine elektrisch isolierende Isolierung umgeben sein. Die Isolierung kann insbesondere aus einem nichtleitenden Plastikmaterial bestehen. Die Isolierung kann so ausgeführt sein, dass jederzeit und überall ein notwendiger Abstand des Prüffingers von den stromführenden Teilen gewährleistet ist.

Durch den hier vorgestellten Ansatz kann der Übergangswiderstand trotz Isolierung direkt an der Schnittstelle gemessen werden.

Es wird ein Verfahren zum Erfassen eines Übergangswiderstands einer berührsicheren Schnittstelle zwischen einer ersten Hochvoltkomponente und einer zweiten Hochvoltkomponente vorgestellt, wobei die Schnittstelle durch eine Isolierung berührsicher geschützt ist, wobei ein erster Messfühler in ein an einer ersten Seite der Schnittstelle angeordnetes erstes berührsicheres Messfenster der Isolierung eingeführt wird und auf einen ersten Leiter der ersten Hochvoltkomponente aufgesetzt wird, wobei ein zweiter Messfühler in ein an einer zweiten Seite der Schnittstelle angeordnetes zweites berührsicheres Messfenster eingeführt wird und auf einen zweiten Leiter der zweite Hochvoltkomponente aufgesetzt wird, wobei über den ersten Messfühler und den zweiten Messfühler ein elektrisches Signal durch die Schnittstelle geleitet wird und zwischen dem ersten Messfühler und dem zweiten Messfühler eine resultierende elektrische Größe an der Schnittstelle gemessen wird, wobei der Übergangswiderstand unter Verwendung des Signals und der elektrischen Größe bestimmt wird.

Weiterhin wird eine Schnittstelle zwischen einer ersten Hochvoltkomponente und einer zweiten Hochvoltkomponente vorgestellt, wobei die Schnittstelle durch eine Isolierung berührsicher geschützt ist, wobei an einer ersten Seite der Schnittstelle ein erstes berührsicheres Messfenster zum Einführen eines ersten Messfühlers und zum Aufsetzen des ersten Messfühlers auf einen ersten Leiter der ersten Hochvoltkomponente in der Isolierung angeordnet ist und an einer zweiten Seite der Schnittstelle ein zweites berührsicheres Messfenster zum Einführen eines zweiten Messfühlers und zum Aufsetzen des zweiten Messfühlers auf einen zweiten Leiter der zweiten Hochvoltkomponente angeordnet ist.

Die berührsicheren Messfenster ermöglichen eine zerstörungsfreie Kontaktierung des ersten Leiters bzw. des zweiten Leiters, d.h. der Messstellen, um den Übergangswiderstands der Schnittstelle zu messen. Bisher war hierfür, insbesondere im Hochvoltbereich, ein Beschädigen der Isolierung notwendig.

Insbesondere wird der erste Messfühler auf eine Stromschiene aufgesetzt. Der zweite Messfühler wird auf ein Modulterminal einer Hochvoltbatterie aufgesetzt.

Unter einem Übergangswiderstand kann ein elektrischer Widerstand, insbesondere ein ohmscher Widerstand zwischen zwei Leitern, also im Betrieb stromführenden Teilen verstanden werden. An einer Schnittstelle können sich Oberflächen der Leiter berühren. Die Oberflächen können mit einer Anpresskraft gegeneinandergepresst werden. Die Leiter sind Bestandteile der Hochvoltkomponenten. Die Hochvoltkomponenten können beispielsweise Stromschienen, Terminals, Sicherungen, oder Schalter sein. Insbesondere kann die erste Hochvoltkomponente eine Stromschiene sein. Die zweite Hochvoltkomponente kann ein Modulterminal sein. Zumindest die erste Hochvoltkomponente kann eine zugehörige Isolierung aufweisen. Die Isolierung kann fest mit dem Leiter verbunden sein. Die Isolierung kann als berührsicher bezeichnet werden, wenn ein standardisierter Prüffinger mindestens in einem festgelegten Abstand zu allen Leitern gehalten wird. Die Isolierung kann eine Materialstärke aufweisen, die für eine KFZ-Hochvoltspannung von mehreren hundert Volt ausgelegt ist. Die Isolierung kann auch der KFZ-Hochvoltspannung und den erforderlichen Prüfspannungen entsprechende Luft- und Kriechstrecken sicherstellen.

Ein Messfenster kann ein Durchbruch durch die Isolierung sein. Die Messfenster können Abmessungen aufweisen, die das Eindringen des Prüffingers unmöglich machen. Eine kleinste Abmessung der Messfenster kann insbesondere kleiner als eine kleinste Abmessung des Prüffingers sein. Die Messfenster können beispielsweise runde Löcher in der Isolierung sein.

Die Messfühler können mit einem Messgerät verbunden sein. Die Messfühler können an einem Roboterarm befestigt sein. Die Messfühler können geradlinig in die Messfenster eingeführt werden. Die Messfenster können passend zu den Messfühlern dimensioniert sein. Die Messfenster können um eine Toleranz größer als die Messfühler sein. Die Messfühler können federgelagert sein. Die Messfühler können beim Aufsetzen auf die Leiter einfedern und so mit einer definierten Kraft gegen die Leiter gepresst werden.

Die Schnittstelle kann zwischen den aufgesetzten Messfühlern liegen. Insbesondere kann die Schnittstelle mittig zwischen den Messfühlern liegen. Ein elektrisches Signal kann ein elektrischer Stromfluss sein. Dann kann die elektrische Größe eine elektrische Spannung beziehungsweise ein Spannungsabfall sein. Der Übergangswiderstand kann unter Verwendung eines Zusammenhangs aus Stromfluss und Spannung bestimmt werden.

Das elektrische Signal kann zwischen einer ersten Messspitze des ersten Messfühlers und einer ersten Messspitze des zweiten Messfühlers angelegt werden. Die elektrische Größe kann zwischen einer zweiten Messspitze des ersten Messfühlers und einer zweiten Messspitze des zweiten Messfühlers gemessen werden. Die Messfühler können je zwei Messspitzen aufweisen. Der Übergangswiderstand kann unter Verwendung einer Vierpunktmessung bestimmt werden. Durch die unterschiedlichen Messspitzen können sich unbekannte Widerstände zwischen den Messspitzen und den Leitern gegenseitig kompensieren und der Übergangswiderstand mit einer hohen Genauigkeit bestimmt werden.

Der erste Leiter kann den zweiten Leiter im Bereich der Schnittstelle überlappen. Der zweite Messfühler kann neben einer Kante des ersten Leiters auf den zweiten Leiter aufgesetzt werden. Durch die Überlappung kann der zweite Leiter tiefer liegen als der erste Leiter. Der zweite Messfühler kann deshalb weiter in das zweite Messfenster eingeführt werden als der erste Messfühler. Der zweite Messfühler kann beabstandet zu der Kante des ersten Leiters auf den zweiten Leiter aufgesetzt werden. Der erste Messfühler kann dabei auf eine von der Schnittstelle abgewandte Seite des ersten Leiters aufgesetzt werden.

Der erste Leiter kann den zweiten Leiter im Bereich der Schnittstelle überlappen. Der erste Leiter kann eine an dem zweiten Messfenster ausgerichtete Aussparung zum Aufsetzen des zweiten Messfühlers auf den zweiten Leiter innerhalb der Schnittstelle aufweisen. Der zweite Messfühler kann innerhalb der Aussparung des ersten Leiters auf den zweiten Leiter aufgesetzt werden. Durch die Aussparung kann der zweite Messfühler quasi innerhalb der Schnittstelle auf den zweiten Leiter aufgesetzt werden. Zum Ausgleich kann der erste Messfühler um die gleiche Strecke innerhalb des Bereichs der Schnittstelle auf den ersten Leiter aufgesetzt werden.

Die Messfühler können in einem definierten Abstand zueinander auf die Leiter aufgesetzt werden. Die Messfühler können insbesondere auf einer Linie der kürzesten Ausdehnung der Schnittstelle aufgesetzt werden. Die Messfühler könne innerhalb eines Bereichs der Schnittstelle aufgesetzt werden. Durch einen definierten Abstand zueinander kann eine hohe Widerholgenauigkeit der Messung erreicht werden. Der Abstand kann durch Positionen der Messfenster vorgegeben sein.

Die Isolierung kann mit dem ersten Leiter verbunden sein. Der zweite Messfühler kann in das durch die Isolierung ausgebildete zweite Messfenster eingeführt werden. Beide Messfenster können innerhalb der gleichen Isolierung angeordnet sein. Die Isolierung kann die Schnittstelle vollständig abdecken.

Alternativ kann der zweite Messfühler in das zwischen der Isolierung des ersten Leiters und einer Isolierung des zweiten Leiters angeordnete zweite Messfenster eingeführt werden. Der zweite Leiter kann eine eigene Isolierung aufweisen. Das zweite Messfenster kann durch einen Spalt zwischen den Isolierungen ausgebildet sein. Der Spalt kann schmal genug sein, dass er berührsicher ist.

### Kurze Figurenbeschreibung

Nachfolgend wird ein vorteilhaftes Ausführungsbeispiel der Erfindung unter Bezugnahme auf die begleitenden Figuren erläutert. Es zeigen:
Fig. 1 eine Schnittdarstellung durch eine Schnittstelle zwischen zwei Hochvoltkomponenten mit einer Messung gemäß einem Ausführungsbeispiel; und
Fig. 2 eine Darstellung einer Vierpunktmessung gemäß einem Ausführungsbeispiel.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

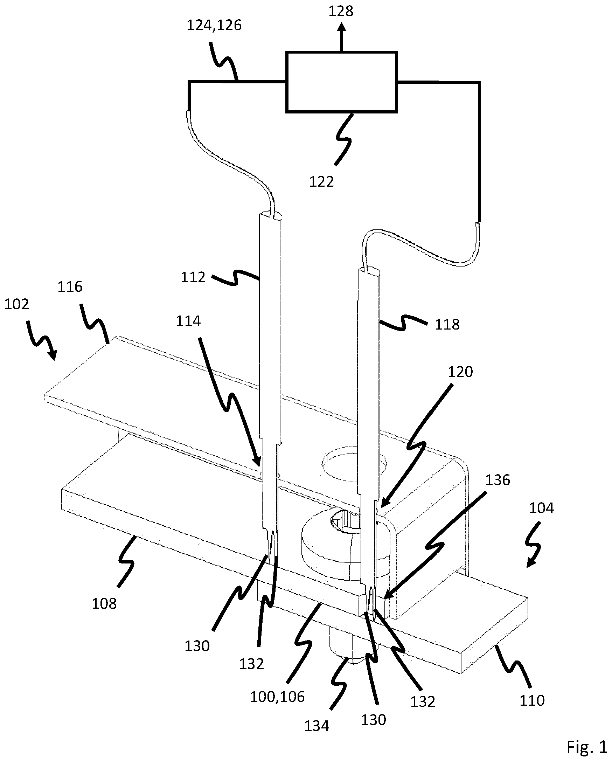

Fig. 1 zeigt eine Schnittdarstellung durch eine Schnittstelle 100 zwischen zwei Hochvoltkomponenten 102, 104 mit einer Messung eines Übergangswiderstands 106 der Schnittstelle 100 gemäß einem Ausführungsbeispiel. An der Schnittstelle 100 sind ein erster Leiter 108 der ersten Hochvoltkomponente 102 und ein zweiter Leiter 110 der zweiten Hochvoltkomponente 104 miteinander verschraubt und damit elektrisch leitend verbunden. Für die Messung wird ein erster Messfühler 112 durch ein erstes Messfenster 114 einer Isolierung 116 der ersten Hochvoltkomponente 102 eingeführt und auf den ersten Leiter 108 aufgesetzt. Ein zweite Messfühler 118 wird durch ein zweites Messfenster 120 der Isolierung 116 eingeführt und auf den zweiten Leiter 110 aufgesetzt. Die Messfenster 114, 120 sind über gegenüberliegenden Seiten der Schnittstelle 100 angeordnet. Die Schnittstelle 100 ist so im Wesentlichen zwischen den Messfühlern 112, 118 angeordnet. Die Messfühler 112, 118 sind mit einem Messgerät 122 verbunden. Das Messgerät 122 leitet ein elektrisches Signal 124 durch die Schnittstelle 100. In Abhängigkeit von dem Übergangswiderstand 106 der Schnittstelle 100 misst das Messgerät 122 eine elektrische Größe 126 zwischen den Messfühlern 112, 118. Unter Verwendung des Signals 124 und der elektrischen Größe 126 bestimmt das Messgerät 122 den Übergangswiderstand 106 und gibt einen Übergangswiderstandswert 128 aus.

In einem Ausführungsbeispiel weisen die Messfühler 112, 118 je eine erste Messspitze 130 und eine zweite Messspitze 132 auf. Das Messgerät 122 legt das elektrische Signal 124 zwischen den ersten Messspitzen 130 an und misst die elektrisch Größe 126 zwischen den zweiten Messspitzen 132. Dadurch werden die undefinierten Widerstände zwischen dem Messgerät 122 und der Schnittstelle 100 kompensiert.

In einem Ausführungsbeispiel ist die erste Hochvoltkomponente 102 eine Stromschiene 102 und die zweite Hochvoltkomponente 104 ist ein Modulterminal 104 eines Batteriemoduls. Die Isolierung 116 ist Teil der Stromschiene 102.

In einem Ausführungsbeispiel überlappen sich die zwei Leiter 108, 110 an der Schnittstelle 100. Dabei wird der erste Leiter 108 durch zwei Schrauben 134 gegen den zweiten Leiter 110 gepresst. Die Schrauben 134 sind auf einer quer zu den Leitern 108, 110, mittig durch die Schnittstelle 100 verlaufenden Linie angeordnet. Durch die Überlappung bilden die Leiter 108, 110 an der Schnittstelle 100 eine Stufe aus. Der zweite Messfühler 118 wird neben einer Stirnseite des ersten Leiters 108 auf den zweiten Leiter 110 aufgesetzt. Der zweite Messfühler 118 eilt dem ersten Messfühler 112 also um eine Materialstärke des ersten Leiters 108 voraus und taucht somit tiefer in die Isolierung 116 ein als der erste Messfühler 112. Der erste Messfühler 112 wird auf einer von der Schnittstelle 100 abgewandten Rückseite des ersten Leiters 108 aufgesetzt.

In einem Ausführungsbeispiel liegt die Isolierung 116 an einer Stirnseite des ersten Leiters 108 an. Daher weist der erste Leiter 108 eine Aussparung 136 für die Messung des Übergangswiderstands 106 auf. Der zweite Messfühler 118 wird innerhalb der Aussparung 136 auf den zweiten Leiter 110 aufgesetzt. Dabei setzt der zweite Messfühler 118 quasi innerhalb der Schnittstelle 100 auf. Zum Ausgleich wird auch der erste Messfühler 112 innerhalb der Schnittstelle 100 auf die Rückseite des ersten Leiters 108 aufgesetzt.

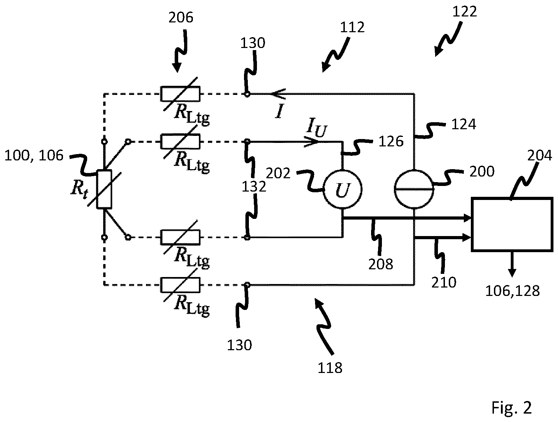

Fig. 2 zeigt eine Darstellung einer Vierpunktmessung gemäß einem Ausführungsbeispiel. Die Vierpunktmessung wird unter Verwendung von Messfühlern 112, 118 mit je zwei Messspitzen 130, 132 ausgeführt. Die vier Messspitzen 130, 132 entsprechen den vier Punkten der Vierpunktmessung. Das Messgerät 122 ist über vier Adern mit den Messspitzen 130, 132 verbunden. Ein Signalerzeuger 200 des Messgeräts 122 ist mit den ersten Messspitzen 130 verbunden und sendet das elektrische Signal 124 durch die Schnittstelle 100. Ein Messwertaufnehmer 202 des Messgeräts 122 ist mit den zweiten Messspitzen 132 verbunden und erfasst die resultierende elektrische Größe 126. Eine Verarbeitungseinrichtung 204 des Messgeräts 122 bestimmt unter Verwendung des elektrischen Signals 124 und der elektrischen Größe 126 den Übergangswiderstand 106 der Schnittstelle 100.

Da die Messspitzen 130, 132 nicht unmittelbar an der Schnittstelle 100 auf die Leiter aufgesetzt werden können, existieren unbekannte Leitungswiderstände 206 zwischen den Messspitzen 130, 132 und der Schnittstelle 100. Durch die Messung über vier Punkte heben sich diese Leitungswiderstände 206 gegenseitig auf.

In einem Ausführungsbeispiel wird als das elektrische Signal 124 ein elektrischer Stromfluss durch die Schnittstelle 100 eingeprägt. Das Messgerät 122 erfasst einen Spannungsabfall 208 über die Schnittstelle 100. Die Verarbeitungseinrichtung 202 bestimmt den Übergangswiderstand 106 unter Verwendung einer Stromstärke 210 des elektrischen Stromflusses und des Spannungsabfalls 208. Die Verarbeitungseinrichtung 204 bildet den Übergangswiderstand 106 in dem Übergangswiderstandswert 128 ab.

Da es sich bei der vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft gewählt.

### BEZUGSZEICHENLISTE

- 100: Schnittstelle
- 102: erste Hochvoltkomponente, Stromschiene
- 104: zweite Hochvoltkomponente, Modulterminal
- 106: Übergangswiderstand
- 108: erster Leiter
- 110: zweiter Leiter
- 112: erster Messfühler
- 114: erstes Messfenster
- 116: Isolierung
- 118: zweiter Messfühler
- 120: zweites Messfenster
- 122: Messgerät
- 124: elektrisches Signal
- 126: elektrische Größe
- 128: Übergangswiderstandswert
- 130: erste Messspitze
- 132: zweite Messspitze
- 134: Schraube
- 136: Aussparung

- 200: Signalerzeuger
- 202: Messwertaufnehmer
- 204: Verarbeitungseinrichtung
- 206: Leitungswiderstand
- 208: Spannungsabfall
- 210: Stromstärke

## Patentansprüche

1. Verfahren zum Erfassen eines Übergangswiderstands (106) einer berührsicheren Schnittstelle (100) zwischen einer ersten Hochvoltkomponente (102) und einer zweiten Hochvoltkomponente (104), wobei die Schnittstelle (100) durch eine Isolierung (116) berührsicher geschützt ist, wobei ein erster Messfühler (112) in ein an einer ersten Seite der Schnittstelle (100) angeordnetes erstes berührsicheres Messfenster (114) der Isolierung (116) eingeführt wird und auf einen ersten Leiter (108) der ersten Hochvoltkomponente (102) aufgesetzt wird, wobei ein zweiter Messfühler (118) in ein an einer zweiten Seite der Schnittstelle (100) angeordnetes zweites berührsicheres Messfenster (120) eingeführt wird und auf einen zweiten Leiter (110) der zweiten Hochvoltkomponente (104) aufgesetzt wird, wobei über den ersten Messfühler (112) und den zweiten Messfühler (118) ein elektrisches Signal (124) durch die Schnittstelle (100) geleitet wird und zwischen dem ersten Messfühler (112) und dem zweiten Messfühler (114) eine resultierende elektrische Größe (126) an der Schnittstelle (100) gemessen wird, wobei der Übergangswiderstand (106) unter Verwendung des Signals (124) und der elektrischen Größe (126) bestimmt wird.

2. Verfahren gemäß Anspruch 1, bei dem das elektrische Signal (124) zwischen einer ersten Messspitze (130) des ersten Messfühlers (112) und einer ersten Messspitze (130) des zweiten Messfühlers (118) angelegt wird, und die elektrische Größe (126) zwischen einer zweiten Messspitze (132) des ersten Messfühlers (112) und einer zweiten Messspitze (132) des zweiten Messfühlers (118) gemessen wird.

3. Verfahren gemäß einem der vorhergehenden Ansprüche, bei dem der erste Leiter (108) den zweiten Leiter (110) im Bereich der Schnittstelle (100) überlappt, wobei der zweite Messfühler (118) neben einer Kante des ersten Leiters (108) auf den zweiten Leiter (110) aufgesetzt wird.

4. Verfahren gemäß Anspruch 3, bei dem der zweite Messfühler (118) innerhalb einer Aussparung (136) des ersten Leiters (108) auf den zweiten Leiter (110) aufgesetzt wird.

5. Verfahren gemäß einem der vorhergehenden Ansprüche, bei dem die Messfühler (112, 118) in einem definierten Abstand zueinander auf die Leiter (108, 110) aufgesetzt werden.

6. Verfahren gemäß einem der vorhergehenden Ansprüche, bei dem die Isolierung (116) mit dem ersten Leiter (108) verbunden ist, wobei der zweite Messfühler (118) in das durch die Isolierung (116) ausgebildete zweite Messfenster (120) eingeführt wird.

7. Verfahren gemäß einem der Ansprüche 1 bis 5, bei dem die Isolierung (116) mit dem ersten Leiter (108) verbunden ist, wobei der zweite Messfühler (118) in das zwischen der Isolierung (116) und einer Isolierung des zweiten Leiters (110) angeordnete zweite Messfenster (120) eingeführt wird.

8. Verfahren gemäß einem der vorhergehenden Ansprüche, bei dem der erste Messfühler (112) auf eine Stromschiene (102) aufgesetzt wird, wobei der zweite Messfühler (118) auf ein Modulterminal (104) einer Hochvoltbatterie aufgesetzt wird.

9. Schnittstelle (100) zwischen einer ersten Hochvoltkomponente (102) und einer zweiten Hochvoltkomponente (104), wobei die Schnittstelle (100) durch eine Isolierung (116) berührsicher geschützt ist, wobei an einer ersten Seite der Schnittstelle (100) ein erstes berührsicheres Messfenster (114) zum Einführen eines ersten Messfühlers (112) und zum Aufsetzen des ersten Messfühlers (112) auf einen ersten Leiter (108) der ersten Hochvoltkomponente (102) in der Isolierung (116) angeordnet ist und an einer zweiten Seite der Schnittstelle (100) ein zweites berührsicheres Messfenster (120) zum Einführen eines zweiten Messfühlers (118) und zum Aufsetzen des zweiten Messfühlers (118) auf einen zweiten Leiter (110) der zweiten Hochvoltkomponente (104) angeordnet ist.

10. Schnittstelle (100) gemäß Anspruch 9, bei der der erste Leiter (108) den zweiten Leiter (110) im Bereich der Schnittstelle (100) überlappt, wobei der erste Leiter (108) eine an dem zweiten Messfenster (120) ausgerichtete Aussparung (136) zum Aufsetzen des zweiten Messfühlers (118) auf den zweiten Leiter (110) innerhalb der Schnittstelle (100) aufweist.

## Claims

1. Method for detecting a contact resistance (106) of a touch-safe interface (100) between a first high-voltage component (102) and a second high-voltage component (104), wherein the interface (100) is protected in a touch-safe manner by an insulation (116), wherein a first sensor (112) is inserted into a first touch-safe measuring window (114) of the insulation (116), , and is placed onto a first conductor (108) of the first high-voltage component (102), the first touch-safe measuring window (114) being arranged on a first side of the interface (100), wherein a second sensor (118) is inserted into a second touch-safe measuring window (120), which is arranged on a second side of the interface (100), and is placed onto a second conductor (110) of the second high-voltage component (104), wherein an electrical signal (124) is routed through the interface (100) via the first sensor (112) and the second sensor (118) and a resulting electrical quantity (126) across the interface (100) between the first sensor (112) and the second sensor (114) is measured, wherein the contact resistance (106) is determined using the signal (124) and the electrical quantity (126).

2. Method according to Claim 1, in which the electrical signal (124) is applied between a first measuring tip (130) of the first sensor (112) and a first measuring tip (130) of the second sensor (118), and the electrical quantity (126) is measured between a second measuring tip (132) of the first sensor (112) and a second measuring tip (132) of the second sensor (118).

3. Method according to either of the preceding claims, in which the first conductor (108) overlaps the second conductor (110) in the region of the interface (100), wherein the second sensor (118) is placed onto the second conductor (110) alongside an edge of the first conductor (108).

4. Method according to Claim 3, in which the second sensor (118) is placed onto the second conductor (110) within a recess (136) of the first conductor (108).

5. Method according to one of the preceding claims, in which the sensors (112, 118) are placed on the conductors (108, 110) at a defined distance from one another.

6. Method according to one of the preceding claims, in which the insulation (116) is connected to the first conductor (108), wherein the second sensor (118) is inserted into the second measuring window (120) formed through the insulation (116).

7. Method according to one of Claims 1 to 5, in which the insulation (116) is connected to the first conductor (108), wherein the second sensor (118) is inserted into the second measuring window (120) which is arranged between the insulation (116) and an insulation of the second conductor (110).

8. Method according to one of the preceding claims, in which the first sensor (112) is placed onto a busbar (102), wherein the second sensor (118) is placed onto a module terminal (104) of a high-voltage battery.

9. Interface (100) between a first high-voltage component (102) and a second high-voltage component (104), wherein the interface (100) is protected in a touch-safe manner by an insulation (116), wherein a first touch-safe measuring window (114) for the insertion of a first sensor (112) and for the placement of the first sensor (112) onto a first conductor (108) of the first high-voltage component (102) is arranged in the insulation (116) on a first side of the interface (100) and a second touch-safe measuring window (120) for the insertion of a second sensor (118) and for the placement of the second sensor (118) onto a second conductor (110) of the second high-voltage component (104) is arranged on a second side of the interface (100).

10. Interface (100) according to Claim 9, in which the first conductor (108) overlaps the second conductor (110) in the region of the interface (100), wherein the first conductor (108) has a recess (136) aligned with the second measuring window (120) for placing the second sensor (118) onto the second conductor (110) within the interface (100).

## Revendications

1. Procédé permettant de détecter une résistance de contact (106) d'une interface sans danger au toucher (100) entre un premier composant haute tension (102) et un deuxième composant haute tension (104), dans lequel l'interface (100) est protégée sans danger au toucher par une isolation (116), dans lequel une première sonde de mesure (112) est introduite dans une première fenêtre de mesure (114) sans danger au toucher de l'isolation (116), disposée sur un premier côté de l'interface (100), et est posée sur un premier conducteur (108) du premier composant haute tension (102), dans lequel une deuxième sonde de mesure (118) est introduite dans une deuxième fenêtre de mesure (120) sans danger au toucher, disposée sur un deuxième côté de l'interface (100), et est posée sur un deuxième conducteur (110) du deuxième composant haute tension (104), dans lequel un signal électrique (124) est acheminé par la première sonde de mesure (112) et la deuxième sonde de mesure (118) à travers l'interface (100), et une grandeur électrique (126) résultante est mesurée à l'interface (100) entre la première sonde de mesure (112) et la deuxième sonde de mesure (114), dans lequel la résistance de contact (106) est déterminée en utilisant le signal (124) et la grandeur électrique (126).

2. Procédé selon la revendication 1, dans lequel le signal électrique (124) est appliqué entre une première pointe de mesure (130) de la première sonde de mesure (112) et une première pointe de mesure (130) de la deuxième sonde de mesure (118), et la grandeur électrique (126) est mesurée entre une deuxième pointe de mesure (132) de la première sonde de mesure (112) et une deuxième pointe de mesure (132) de la deuxième sonde de mesure (118).

3. Procédé selon l'une quelconque des revendications précédentes, dans lequel le premier conducteur (108) se chevauche avec le deuxième conducteur (110) dans la zone de l'interface (100), dans lequel la deuxième sonde de mesure (118) est posée sur le deuxième conducteur (110) à côté d'une arête du premier conducteur (108).

4. Procédé selon la revendication 3, dans lequel la deuxième sonde de mesure (118) est posée à l'intérieur d'un évidement (136) du premier conducteur (108) sur le deuxième conducteur (110).

5. Procédé selon l'une quelconque des revendications précédentes, dans lequel les sondes de mesure (112, 118) sont posées sur les conducteurs (108, 110) à une distance définie l'une par rapport à l'autre.

6. Procédé selon l'une quelconque des revendications précédentes, dans lequel l'isolation (116) est reliée au premier conducteur (108), dans lequel la deuxième sonde de mesure (118) est introduite dans la deuxième fenêtre de mesure (120) réalisée à travers l'isolation (116).

7. Procédé selon l'une quelconque des revendications 1 à 5, dans lequel l'isolation (116) est reliée au premier conducteur (108), dans lequel la deuxième sonde de mesure (118) est introduite dans la deuxième fenêtre de mesure (120) disposée entre l'isolation (116) et une isolation du deuxième conducteur (110).

8. Procédé selon l'une quelconque des revendications précédentes, dans lequel la première sonde de mesure (112) est posée sur une barre conductrice (102), dans lequel la deuxième sonde de mesure (118) est posée sur une borne de module (104) d'une batterie haute tension.

9. Interface (100) entre un premier composant haute tension (102) et un deuxième composant haute tension (104), dans laquelle l'interface (100) est protégée sans danger au toucher par une isolation (116), dans laquelle sur un premier côté de l'interface (100), une première fenêtre de mesure (114) sans danger au toucher est disposée dans l'isolation (116) pour introduire une première sonde de mesure (112) et pour poser la première sonde de mesure (112) sur un premier conducteur (108) du premier composant haute tension (102), et sur un deuxième côté de l'interface (100), une deuxième fenêtre de mesure (120) sans danger au toucher est disposée pour introduire une deuxième sonde de mesure (118) et pour poser la deuxième sonde de mesure (118) sur un deuxième conducteur (110) du deuxième composant haute tension (104).

10. Interface (100) selon la revendication 9, dans laquelle le premier conducteur (108) se chevauche avec le deuxième conducteur (110) dans la zone de l'interface (100), dans laquelle le premier conducteur (108) présente un évidement (136) aligné sur la deuxième fenêtre de mesure (120) pour poser la deuxième sonde de mesure (118) sur le deuxième conducteur (110) à l'intérieur de l'interface (100).
